# EUROPÄISCHE PATENTANMELDUNG

(11) **EP 0 930 550 A2**
(43) Veröffentlichungstag der Anmeldung: **21.07.1999**
(21) Anmeldenummer: 98122790.3
(22) Anmeldetag: 01.12.1998
(51) Int. Cl.: G03H 1/28

(54) **Vorrichtung und Verfahren zur optischen Aufnahme, Speicherung und Wiedergabe von Informationen**

(30) Priorität: 16.01.1998 DE 19801470
(71) Anmelder: Weitzel, Thilo, 72070 Tübingen (DE)
(72) Erfinder: Weitzel, Thilo, 72070 Tübingen (DE)
(74) Vertreter: Laufhütte, Dieter, Dr.-Ing.

(57) **Zusammenfassung**

Vorrichtung zur optischen Aufnahme, Speicherung und Wiedergabe von Informationen mit wenigstens einem Speicherelement, in dem Interferenzmuster speicherbar sind und/oder das eine lichtbeugende Struktur aufweist und/oder in dem eine lichtbeugende Struktur erzeugbar ist, Mitteln zur Erzeugung von mindestens zwei Lichtstrahlen, wobei mindestens zwei der Lichtstrahlen derart ausrichtbar sind, daß sie in dem Speicherelement unter Bildung eines Interferenzmusters zusammenführbar sind, Mitteln zur Frequenzkontrolle oder Frequenzverschiebung und/oder - modulation oder zur Phasenverschiebung und/oder -modulation, durch die wenigstens einer der auf das Speicherelement geführten Lichtstrahlen modulierbar ist, wenigstens einem Detektor zur Erfassung der Lichtstrahlen sowie mit wenigstens einem Demodulator und/oder optischen Elementen, mittels derer eine zeitliche und/oder räumliche Modulation der Intensität bezogen auf den gesamten oder Teile des detektierten Strahlquerschnittes meßbar ist.

Eine hohe Speicherkapazität bei verhältnismäßig geringen Anforderungen an die optische Qualität der verwendeten Komponenten ist erfindungsgemäß dadurch möglich, daß das die Mittel zur Erzeugung der mindestens zwei Lichtstrahlen und/oder das Speicherelement und/oder Mittel zur Führung der Lichtstrahlen derart ausgeführt sind, daß die räumliche Orientierung des durch die Lichtstrahlen im Speicherelement erzeugten Interferenzmusters gegenüber der räumlichen Orientierung eines im Speicherelement gespeicherten Interferenzmusters und/oder einer im Speicherelement vorliegenden lichtbeugenden Struktur in allen Raumrichtungen veränderbar ist. Die Erfindung betrifft ferner eine Vorrichtung zur Wiedergabe optischer Informationen sowie Verfahren zur optischen Aufnahme sowie zur optischen Wiedergabe von Informationen.

## Beschreibung

Die vorliegende Erfindung betrifft eine Vorrichtung zur optischen Aufnahme, Speicherung und Wiedergabe von Informationen mit wenigstens einem Speicherelement, in dem Interferenzmuster speicherbar sind und/oder das eine lichtbeugende Struktur aufweist und/oder in dem eine lichtbeugende Struktur erzeugbar ist, Mitteln zur Erzeugung von mindestens zwei Lichtstrahlen, wobei mindestens zwei der Lichtstrahlen derart ausrichtbar sind, daß sie in dem Speicherelement unter Bildung eines Interferenzmusters zusammenführbar sind, Mitteln zur Frequenzkontrolle oder Frequenzverschiebung und/oder -modulation oder zur Phasenverschiebung und/oder -modulation, durch die wenigstens einer der auf das Speicherelement geführten Lichtstrahlen modulierbar ist, wenigstens einem Detektor zur Erfassung der Lichtstrahlen sowie mit wenigstens einem Demodulator und/oder optischen Elementen, mittels derer eine zeitliche und/oder räumliche Modulation der Intensität bezogen auf den gesamten oder Teile des detektierten Strahlquerschnittes meßbar ist.

Die Erfindung betrifft ferner eine Vorrichtung zur optischen Wiedergabe von Informationen mit wenigstens einem Speicherelement, in dem Interferenzmuster speicherbar sind und/oder das eine lichtbeugende Struktur aufweist und/oder in dem eine lichtbeugende Struktur erzeugbar ist, Mitteln zur Erzeugung von mindestens einem Lichtstrahl, wobei mindestens ein Lichtstrahl auf das Speicherelement ausrichtbar ist, wobei mit dem Speicherelement mindestens ein weiterer Lichtstrahl erzeugbar ist und wobei mindestens zwei Lichtstrahlen derart ausrichtbar sind, daß sie unter Bildung eines Interferenzmusters zusammenführbar sind, Mitteln zur Frequenzkontrolle und/oder Frequenzverschiebung und/oder -modulation oder zur Phasenverschiebung und/oder -modulation, durch die wenigstens einer der zusammengeführten Lichtstrahlen modulierbar ist, wenigstens einem Detektor zur Erfassung der Lichtstrahlen sowie mit wenigstens einem Demodulator und/oder optischen Elementen, mittels derer eine zeitliche und/oder räumliche Modulation der Intensität bezogen auf den gesamten oder Teile des detektierten Strahlquerschnittes meßbar ist.

Die Erfindung betrifft weiterhin die Verwendung der erfindungsgemäßen Vorrichtungen zur optischen Aufnahme, Speicherung und/oder Wiedergabe von Informationen.

Die Erfindung betrifft ferner ein Verfahren zur optischen Aufnahme von Informationen, bei dem in einem Speicherelement, das eine lichtbeugende Struktur aufweist und/oder in dem lichtbeugende Strukturen erzeugbar sind, zum Zwecke der Aufnahme wenigstens zwei Lichtstrahlen unter Bildung eines Interferenzmusters zusammengeführt werden sowie ein Verfahren zur optischen Wiedergabe von Informationen aus einem Speicherelement, das lichtbeugende Strukturen aufweist, bei dem zum Zwecke des Nachweises einer lichtbeugenden Struktur wenigstens zwei Lichtstrahlen unter Bildung eines Interferenzmusters zusammengeführt werden, wobei die Frequenz oder die Phasenlage mindestens eines der Lichtstrahlen gegenüber dem anderen variiert und/oder moduliert wird und wobei wenigstens einer der Lichtstrahlen von dem Speicherelement ausgeht und von einem Detektor erfaßt wird und wobei eine zeitliche oder räumliche Modulation dieses Lichtstrahls mittels eines Demodulators demoduliert wird.

Optische Speicher werden derzeit üblicherweise als 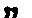 Page Oriented Holographic Memory" (POHM) realisiert. Favorisiert wird derzeit eine konventionelle optische Anordnung in 90-Grad Geometrie zur Aufnahme von Fouriertransformhologrammen und das Winkel-Multiplex-Verfahren zur Selektion der einzelnen Hologramme. Ein unter einem bestimmten Winkel als Hologramm gespeichertes Muster repräsentiert eine 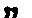 Page", die einzelnen Bildpunkte des Musters ( 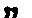 Pixel") repräsentieren die auf dieser Page abgelegte Information. Die Anzahl der im Winkel-Multiplex-Verfahren speicherbaren Pages wird durch die Winkelauflösung der einzelnen Hologramme sowie durch die etwa umgekehrt proportional zum Quadrat der Anzahl der zu speichernden Hologramme abfallende Beugungseffizienz begrenzt. Die derzeitigen Entwicklungen zielen daher auf möglichst hohe Speicherkapazitäten pro Page.

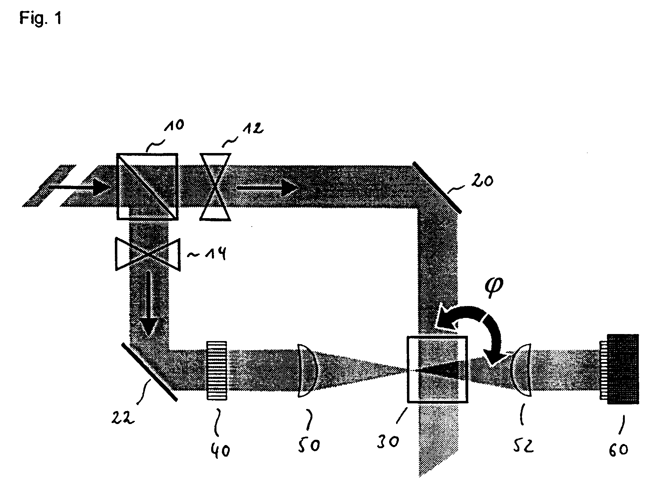

Fig. 1 zeigt den prinzipiellen Aufbau eines POHM. Der Strahlteiler 10 teilt einen einfallenden kohärenten Lichtstrahl in einen "Referenz"- sowie einen "Objekt"-Strahl. Der Referenzstrahl ist durch den Shutter 12 schaltbar und wird über Spiegel 20 auf das Speicherelement 30 geführt. Der Objektstrahl ist durch Shutter 14 schaltbar und wird über Spiegel 22 auf einen Spatial Light Modulator 40 (SLM) geführt. Der SLM 40 repräsentiert die auf einer Seite d.h. als einzelnes Hologramm abzuspeichernde Information als ein Muster von hellen und dunklen Bildpunkten ( 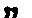 Pixeln"). Dieses Muster wird durch die Linsen 50 und 52 durch das Speicherelement 30 hindurch paßgenau auf eine Kamera, üblicherweise ein Charge Coupled Device (CCD) 60 abgebildet. Das am SLM 40 anliegende Muster wird so durch das CCD 60 rekonstruiert.

Zur Aufnahme einer Seite wird das Speicherelement 30 in eine geeignete Position gedreht, die zu speichernde Information wird am SLM 40 dargestellt und beide Shutter 12, 14 werden für einen geeigneten Zeitraum (Belichtungszeit) geöffnet. Das im Speicherelement 30 resultierende Interferenzmuster wird als Hologramm gespeichert. Unter verschiedenen Drehwinkelpositionen können verschiedene Hologramme gespeichert werden. Um eine bestimmte Seite zu lesen wird das Speicherelement in die bei der Aufnahme dieser Seite verwendete Drehwinkelposition gebracht und nur Shutter 12 geöffnet, d.h. der Referenzstrahl angelegt. Durch das Hologramm wird dann das zum Aufnahmezeitpunkt am SLM 40 anliegende Muster rekonstruiert und auf das CCD 60 abgebildet, wo es abgefragt werden kann.

Um das Signal zu Rausch Verhältnis beim Auslesen der Hologramme zu verbessern, wurde bereits ein heterodyne Detektion Verfahren für holographisch optische Speicher vorgeschlagen. Bei diesem Verfahren muß anstelle des CCDs 60 ein Detektorarray verwendet werden dessen einzelne Elemente ( 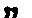 Pixel") durch geeignete Demodulatoren nur auf eine zeitliche Modulation der Intensität des jeweiligen Bildpunktes reagieren. Beim Auslesevorgang wird das am Detektorarray anliegende Bild mit einer zusätzlichen ebenen Welle mit gegenüber dem Referenzstrahl geeignet verschiedener Frequenz überlagert. Die resultierende Interferenz zeigt die erforderliche zeitliche Modulation der einzelnen Bildpunkte.

Bei gattungsgemäßen optischen Speichern ist es von Nachteil, daß die Optimierung der Speicherkapazität durch eine Erhöhung der Anzahl der Seiten sowie insbesondere der Kapazität pro Seite einen erheblichen Aufwand hinsichtlich der Qualität aller optischen Komponenten sowie des Speichermediums bedingt. Die Anzahl der im Winkel-Multiplex-Verfahren speicherbaren Seiten ist durch die physikalischen Gegebenheiten begrenzt, heterodyne Detektion Verfahren scheiden bei einer großen Anzahl von Bildpunkten pro Seite aufgrund des zu treibenden technischen Aufwandes aus. Es ist daher die Aufgabe der vorliegenden Erfindung, eine Vorrichtung und ein Verfahren zur optischen Aufnahme, Speicherung und Wiedergabe von Daten zu schaffen, bei der eine hohe Speicherkapazität bei verhältnismäßig geringen Anforderungen an die optische Qualität der verwendeten Komponenten möglich ist.

Diese Aufgabe wird erfindungsgemäß dadurch gelöst, daß bei einer Vorrichtung zur optischen Aufnahme, Speicherung und Wiedergabe von Informationen die Mittel zur Erzeugung der mindestens zwei Lichtstrahlen und/oder das Speicherelement und/oder Mittel zur Führung der Lichtstrahlen derart ausgeführt sind, daß die räumliche Orientierung des durch die Lichtstrahlen im Speicherelement erzeugten Interferenzmusters gegenüber der räumlichen Orientierung eines im Speicherelement gespeicherten Interferenzmusters und/oder einer im Speicherelement vorliegenden lichtbeugenden Struktur in allen Raumrichtungen veränderbar ist. Bei einer Vorrichtung zur optischen Wiedergabe von Informationen wird die Aufgabe erfindungsgemäß dadurch gelöst, daß die Mittel zur Erzeugung des mindestens einen Lichtstrahls und/oder das Speicherelement und/oder Mittel zur Führung der Lichtstrahlen derart ausgeführt sind, daß der Raumwinkel zwischen den zusammengeführten Strahlen in allen Raumrichtungen veränderbar ist.

Somit wird nicht der Inhalt einer Seite bzw. eines Hologramms gelesen, sondern lediglich dessen Vorhandensein (bzw. nicht Vorhandensein) detektiert. Der Nachweis der einzelnen Hologramme erfolgt hierbei durch ein heterodyne Detektion Verfahren in einer Anordnung, die grundsätzlich als Interferometer betrachtet werden kann. Durch den Verzicht auf die Seiteninformation kann die gesamte Fläche des Strahlquerschnitts für den Nachweis eines Hologramms verwendet werden. In erfindungsgemäßen Vorrichtungen wird explizit der Umstand genutzt, daß bei der dieser Vorgehensweise das nachweisbare Signal nur etwa umgekehrt proportional zur Anzahl der aufzunehmenden Hologramme abnimmt, die Winkelauflösung für das Multiplexing gegenüber konventionellem Auslesen der Hologramme sehr stark erhöht ist, und insbesondere Winkelmultiplexing in allen Raumrichtungen möglich ist. Die genannten Vorteile erhöhen die Anzahl der speicherbaren Hologramme derart, daß gegenüber der konventionellen Anordnung der Verzicht auf die Seiteninformation kompensiert wird.

Besonders vorteilhaft ist es, wenn in dem Speicherelement ein Hologramm, insbesondere ein Multiplex-Hologramm, aufnehmbar ist und/oder das Speicherelement ein Hologramm, insbesondere ein Multiplex-Hologramm, umfaßt. Ebenso ist es möglich entsprechende nicht auf holographischem Wege hergestellte optische Elemente einzusetzen, wie etwa Strukturen aus mehreren dünnen Schichten (dielektrische Spiegel), sonstige periodische Strukturen oder auch optische Gitterstrukturen oder computergenerierte Hologramme.

Gemäß einer bevorzugten Ausgestaltung der vorliegenden Erfindung ist das Speicherelement um mindestens eine Achse drehbar.

In weiterer Ausgestaltung der vorliegenden Erfindung sind die Mittel zur Erzeugung der Lichtstrahlen und/oder das Speicherelement und/oder Mittel zur Führung der Lichtstrahlen derart ausgeführt, daß die Einfallswinkel wenigstens eines der auf das Speicherelement treffenden Lichtstrahlen in mehr als einer Ebene veränderbar sind.

Der Winkel zwischen den im Speicherelement zur Interferenz zusammengeführten Strahlen kann veränderbar sein.

Besonders vorteilhaft ist es, wenn durch die Mittel zur Erzeugung der Lichtstrahlen die Wellenlänge veränderbar ist.

Gemäß einer bevorzugten Ausgestaltung der vorliegenden Erfindung ist das Speicherelement und/oder die Mittel zur Führung der Lichtstrahlen und/oder zusätzliche Elemente derart ausgeführt, daß die Strahlrichtung mindestens eines der Lichtstrahlen in Abhängigkeit von der Wellenlänge veränderbar ist.

In weiterer Ausgestaltung der vorliegenden Erfindung sind Mittel zur Veränderung des Strahlquerschnitts mindestens eines der Lichtstrahlen vorgesehen. Es können ferner Mittel zur spektralen Filterung oder räumlichen Modulation von Phase und/oder Amplitude mindestens eines der Lichtstrahlen vorgesehen sein.

Besonders vorteilhaft ist es, wenn Mittel zur Manipulation der Teilstrahlen oder des Speicherelements vorgesehen sind, die derart ausgeführt sind, daß unabhängig voneinander räumlich getrennte Teilbereiche des Speicherelements schreib- oder lesbar sind. Grundsätzlich besteht die Möglichkeit, das Speicherelement in mehrere räumlich und/oder nach Raumwinkeln und/oder durch Variation des Winkels zwischen den Teilstrahlen und/oder Variation der Wellenfronten unterscheidbare Teilhologramme aufzuspalten und diese Teilhologramme entweder gleichzeitig durch entsprechend viele Modulatoren und Detektoren mit Demodulatoren oder nacheinander unabhängig voneinander schreiben bzw. lesen zu können. Grundsätzlich ist es ebenso möglich, daß gleichzeitig oder nacheinander bei verschiedenen Wellenlängen gearbeitet wird, wobei sowohl die Wellenlängenselektivität des Hologramms als auch eine potentielle Wellenlängenselektivität des Aufnahmematerials genutzt werden kann, oder aber ein dispersives Element unterschiedliche Wellenlängen auf unterschiedliche Winkel abbildet.

In weiterer Ausgestaltung der vorliegenden Erfindung sind Teile der Vorrichtung mehrfach vorgesehen und/oder handhaben mehrere der Strahlen.

Besonders vorteilhaft ist es, wenn alle oder ein Teil der Strahlen ganz oder teilweise durch Lichtleiter geführt werden und/oder wenn alle oder ein Teil der optischen Elemente durch Mittel der integrierten Optik realisiert werden.

Ausgehend von einem gattungsgemäßen Verfahren zur optischen Aufnahme von Informationen wird die der Erfindung zugrundeliegende Aufgabe ferner dadurch gelöst, daß zwischen jeweils zwei Aufnahmen die räumliche Orientierung des durch die Lichtstrahlen erzeugten Interferenzmusters gegenüber der räumlichen Orientierung eines gespeicherten Interferenzmusters und/oder einer lichtbeugenden Struktur in allen Raumrichtungen verändert werden kann. Bei einem gattungsgemäßen Verfahren zur optischen Wiedergabe von Informationen kann zum Nachweis verschiedener lichtbeugender Strukturen die Ausbreitungsrichtung mindestens eines der zur Interferenz beitragenden Lichtstrahlen gegenüber der räumlichen Orientierung einer im Speicherelement gespeicherten lichtbeugenden Struktur in allen Raumrichtungen verändert werden.

Weitere Vorteile und Einzelheiten der erfindungsgemäßen Vorrichtung werden anhand eines in der Zeichnung dargestellten Ausführungsbeispiels näher erläutert. Es zeigen:
- Fig. 2.: einen prinzipiellen Aufbau einer erfindungsgemäßen Vorrichtung zur optischen Aufnahme, Speicherung und Wiedergabe von Informationen,
- Fig. 3.: eine Ausführung des Speicherelementes als drehbarer Zylinder, und
- Fig. 4.: die räumliche und zeitliche Modulation der Intensität am Ort eines Detektors.

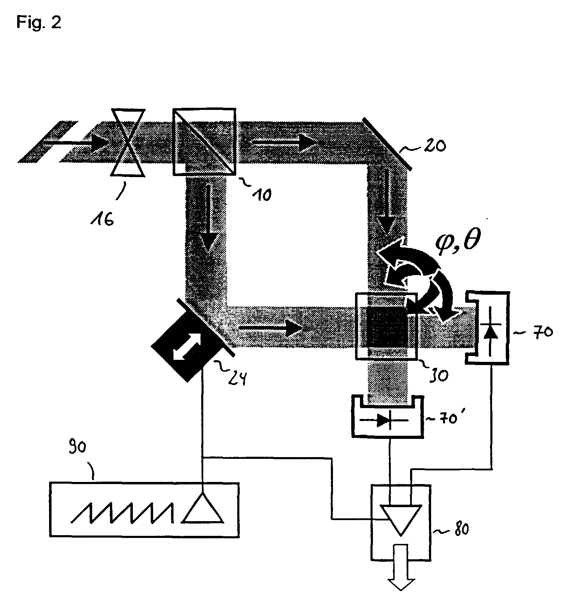

Fig. 2 zeigt einen möglichen prinzipiellen Aufbau der erfindungsgemäßen Vorrichtung. Der einfallende kohärente Lichtstrahl passiert den Shutter 16 und wird durch den Strahlteiler 10 in zwei Teilstrahlen geteilt. Ein Teilstrahl wird über den Spiegel 20 zum Speicherelement 30 geführt, der andere Teilstrahl wird über ein optisches Element 24, das eine Phasenmodulation oder Frequenzverschiebung erlaubt, zum Speicherelement 30 geführt. Im Unterschied zu bekannten Anordnungen ist das Speicherelement 30 um zwei Achsen drehbar ausgeführt, was die Einstellung beliebiger Raumwinkel ermöglicht. Die transmittierten Strahlen werden durch Detektoren 70, 70' erfaßt, welche die Intensität über den gesamten Strahlquerschnitt integrieren. Der Demodulator 80 erfaßt eine zeitliche Modulation der von den Detektoren 70, 70' erfassten Intensitäten. Die Steuerung der Modulation duch das optische Element 24 wird durch die Modulator-Steuerung 90 bewirkt.

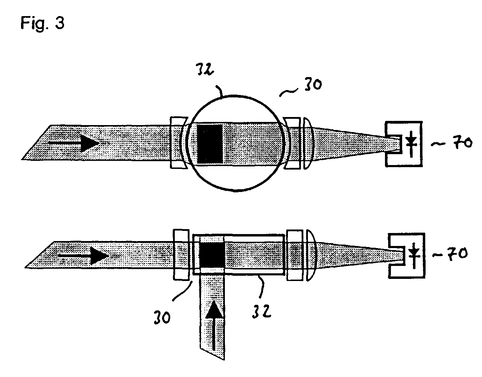

Fig. 3 zeigt eine Detaildarstellung einer vorteilhaften Ausführung des Speicherelements 30 als drehbarer Zylinder 32 in Draufsicht (oben) und in einer Seitenansicht (unten). Der radial geführte Strahl kann moduliert werden und wird weiter auf den Detektor 70 geführt. Eine Koordinate des Raumwinkels wird durch Rotation des Zylinders 32 dargestellt, die zweite Koordinate des Raumwinkels wird durch geeignete Ablenkung des axial geführten Strahls realisiert.

Zur Aufnahme eines Hologramms wird das Speicherelement 30 in eine geeignete Raumwinkelposition gebracht, der Phasen-Modulator bzw. Frequenzschieber des optischen Elementes 24 nicht aktiviert und der Shutter 16 für einen geeigneten Belichtungszeitraum geöffnet. Das im Speicherelement 30 resultierende stationäre Interferenzmuster wird damit als Hologramm gespeichert. Unter verschiedenen Raumwinkelpositionen können unabhängig voneinander Hologramme gespeichert werden.

Zum Nachweis eines bestimmten Hologramms wird das Speicherelement 30 in die entsprechende Raumwinkelposition gebracht, der Phasen-Modulator bzw. Frequenzschieber des optischen Elementes 24 wird aktiviert und der Shutter 16 geöffnet. Die an den Detektoren 70,70' anliegende Überlagerung der vom Speicherelement 30 transmittierten und gebeugten Anteile der Lichtstrahlen zeigt eine charakteristische zeitliche Modulation der Amplitude, die durch den Demodulator 80 nachgewiesen werden kann.

Die in der erfindungsgemäßen Anordnung delektierte zeitliche Modulation kann betrachtet werden als Resultat der Wechselwirkung des zum Auslesen verwendeten wandernden Interferenzmusters mit dem vorher unter den gleichen Bedingungen gespeicherten stationären Interferenzmuster. Die Modulation tritt nur auf, wenn die beiden Muster im gesamten erfaßten Volumen paßgenau justiert sind. Dies erklärt die hohe Raumwinkelauflösung der Anordnung in allen Richtungen.

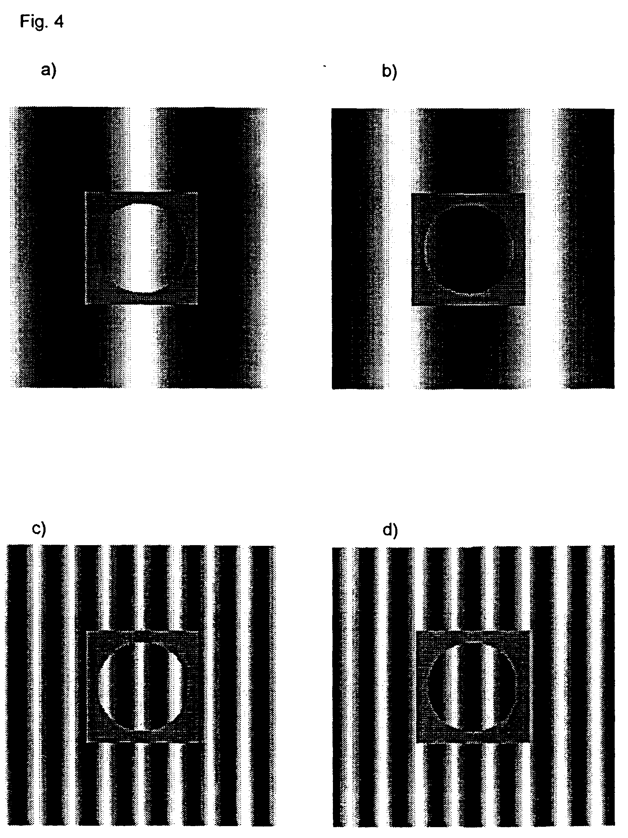

Zur Erläuterung zeigt Fig. 4 die für eine Anordnung mit ebenen Wellen beim Nachweis eines Hologramms resultierende räumliche und zeitliche Modulation der Intensität am Ort eines der Detektoren.

Ist die räumliche Orientierung des Speicherelements 30 nur sehr wenig verschieden von der räumlichen Orientierung bei der Aufnahme des nachzuweisenden Hologramms wird die Periode der räumlichen Modulation des am Detektor 70, 70'anliegenden Interferenzmusters sehr groß. Insbesondere kann die räumliche Periode dieses Interferenzmusters größer werden, als der vom Detektor 70, 70' erfaßte Strahlquerschnitt. Die Fig. 4 a) und 4 b) zeigen diese Situation für zwei Zeitpunkte mit um π unterschiedlicher relativer Phasenlage der Teilstrahlen. Der markierte Bereich im Zentrum der dargestellten Interferenzmuster stellt den vom Detektor 70, 70' erfaßten Bereich der Strahlen dar.

Eine Veränderung der relativen Phasenlage der Teilstrahlen führt zu einer lateralen Verschiebung des Interferenzmusters. In der gezeigten Situation führt dies zu einer sehr starken Modulation der über die erfaßte Fläche integrierten Intensität. Bereits sehr kleine Abweichungen der räumlichen Orientierung der Probe führen zu einer starken Verkleinerung der Periode des jeweiligen Interferenzmusters. Die Fig. 4 c) und 4 d) zeigt eine derartige Situation für zwei Zeitpunkte mit um π unterschiedlicher relativer Phasenlage der Teilstrahlen. Die vom Detektor 70, 70' erfaßte Fläche überlappt mehrere helle und dunkle Streifen. Mit steigender Anzahl der Streifen nimmt die bei der lateralen Verschiebung des Interferenzmusters meßbare Modulation des über die erfaßte Fläche integrierten Interferenzsignals schnell ab.

Der Strahlengang der gezeigten prinzipiellen Anordnung zur optischen Aufnahme, Speicherung und zur Wiedergabe von Informationen entspricht dem Strahlengang in einem Mach-Zehnder-Interferometer. Eine entsprechende Anordnung, bei der Speicherelement und Strahlteiler gegenüber der gezeigten Anordnung vertauscht sind, ist erfindungsgemäß als Vorrichtung nur zum Auslesen von gespeicherten Informationen verwendbar.

Anstelle der Mittel zur freien Einstellung der räumlichen Orientierung des Speicherelements können Mittel treten, die eine entsprechende Änderung der Raumwinkel der beteiligten Lichtstrahlen bzw. der anderen optischen Komponenten erlauben. Weiterhin kann, insbesondere bei nur zum Auslesen geeigneten Varianten der erfindungsgemäßen Vorrichtung, der Strahlengang anderer Interferometer verwendet werden.

Neben oder zusätzlich zum beschriebenen Raumwinkelmultiplexing können mit Hilfe zusätzlicher Elemente weitere Dimensionen nutzbar gemacht werden, etwa Multiplexing durch Variation der Wellenfronten, spektrales Multiplexing oder Multiplexing durch Veränderung des Raumwinkels zwischen den Teilstrahlen.

## Patentansprüche

1. Vorrichtung zur optischen Aufnahme, Speicherung und Wiedergabe von Informationen mit
wenigstens einem Speicherelement (30), in dem Interferenzmuster speicherbar sind und/oder das eine lichtbeugende Struktur aufweist und/oder in dem eine lichtbeugende Struktur erzeugbar ist,
Mitteln (10) zur Erzeugung von mindestens zwei Lichtstrahlen, wobei mindestens zwei der Lichtstrahlen derart ausrichtbar sind, daß sie in dem Speicherelement (30) unter Bildung eines Interferenzmusters zusammenführbar sind,
Mitteln zur Frequenzkontrolle oder Frequenzverschiebung und/oder -modulation oder zur Phasenverschiebung und/oder -modulation (24), durch die wenigstens einer der auf das Speicherelement (30) geführten Lichtstrahlen modulierbar ist,
wenigstens einem Detektor (70,70') zur Erfassung der Lichtstrahlen
sowie mit wenigstens einem Demodulator (80) und/oder optischen Elementen, mittels derer eine zeitliche und/oder räumliche Modulation der Intensität bezogen auf den gesamten oder Teile des detektierten Strahlquerschnittes meßbar ist,
**dadurch gekennzeichnet,**
daß die Mittel (10) zur Erzeugung der mindestens zwei Lichtstrahlen und/oder das Speicherelement (30) und/oder Mittel zur Führung der Lichtstrahlen (20,24) derart ausgeführt sind, daß die räumliche Orientierung des durch die Lichtstrahlen im Speicherelement (30) erzeugten Interferenzmusters gegenüber der räumlichen Orientierung eines im Speicherelement (30) gespeicherten Interferenzmusters und/oder einer im Speicherelement (30) vorliegenden lichtbeugenden Struktur in allen Raumrichtungen veränderbar ist.

2. Vorrichtung zur optischen Wiedergabe von Informationen mit
wenigstens einem Speicherelement, in dem Interferenzmuster speicherbar sind und/oder das eine lichtbeugende Struktur aufweist und/oder in dem eine lichtbeugende Struktur erzeugbar ist,
Mitteln zur Erzeugung von mindestens einem Lichtstrahl, wobei mindestens ein Lichtstrahl auf das Speicherelement ausrichtbar ist, wobei mit dem Speicherelement mindestens ein weiterer Lichtstrahl erzeugbar ist und wobei mindestens zwei Lichtstrahlen derart ausrichtbar sind, daß sie unter Bildung eines Interferenzmusters zusammenführbar sind,
Mitteln zur Frequenzkontrolle und/oder Frequenzverschiebung und/oder - modulation oder zur Phasenverschiebung und/oder -modulation, durch die wenigstens einer der zusammengeführten Lichtstrahlen modulierbar ist,
wenigstens einem Detektor zur Erfassung der Lichtstrahlen
sowie mit wenigstens einem Demodulator und/oder optischen Elementen, mittels derer eine zeitliche und/oder räumliche Modulation der Intensität bezogen auf den gesamten oder Teile des detektierten Strahlquerschnittes meßbar ist,
**dadurch gekennzeichnet,**
daß die Mittel zur Erzeugung des mindestens einen Lichtstrahls und/oder das Speicherelement und/oder Mittel zur Führung der Lichtstrahlen derart ausgeführt sind, daß der Raumwinkel zwischen den zusammengeführten Strahlen in allen Raumrichtungen veränderbar ist.

3. Vorrichtung nach Anspruch 1 oder 2, dadurch gekennzeichnet, daß in dem Speicherelement (30) ein Hologramm, insbesondere ein Multiplex-Hologramm, aufnehmbar ist und/oder daß das Speicherelement (30) ein Hologramm, insbesondere ein Multiplex-Hologramm, umfaßt.

4. Vorrichtung nach einem oder mehreren der Ansprüche 1 bis 3, dadurch gekennzeichnet, daß das Speicherelement (30) um mindestens eine Achse drehbar ist.

5. Vorrichtung nach einem oder mehreren der Ansprüche 1 bis 4, dadurch gekennzeichnet, daß die Mittel (10) zur Erzeugung der Lichtstrahlen und/oder das Speicherelement (30) und/oder Mittel zur Führung der Lichtstrahlen (20,24) derart ausgeführt sind, daß die Einfallswinkel wenigstens eines der auf das Speicherelement (30) treffenden Lichtstrahlen in mehr als einer Ebene veränderbar sind.

6. Vorrichtung nach einem oder mehreren der Ansprüche 1 bis 5, dadurch gekennzeichnet, daß der Winkel zwischen den im Speicherelement (30) zur Interferenz zusammengeführten Strahlen veränderbar ist.

7. Vorrichtung nach einem oder mehreren der Ansprüche 1 bis 6, dadurch gekennzeichnet, daß durch die Mittel zur Erzeugung der Lichtstrahlen (10) die Wellenlänge veränderbar ist.

8. Vorrichtung nach einem oder mehreren der Ansprüche 1 bis 7, dadurch gekennzeichnet, daß das Speicherelement (30) und/oder die Mittel zur Führung der Lichtstrahlen (20,24) und/oder zusätzliche Elemente derart ausgeführt sind, daß die Strahlrichtung mindestens eines der Lichtstrahlen in Abhängigkeit von der Wellenlänge veränderbar ist.

9. Vorrichtung nach einem oder mehreren der Ansprüche 1 bis 8, dadurch gekennzeichnet, daß Mittel zur Veränderung des Strahlquerschnitts mindestens eines der Lichtstrahlen vorgesehen sind.

10. Vorrichtung nach einem oder mehreren der Ansprüche 1 bis 9, dadurch gekennzeichnet, daß Mittel zur spektralen Filterung und/oder räumlichen Modulation von Phase und/oder Amplitude mindestens eines der Lichtstrahlen vorgesehen sind.

11. Vorrichtung nach einem oder mehreren der Ansprüche 1 bis 10, dadurch gekennzeichnet, daß Mittel zur Manipulation der Teilstrahlen oder des Speicherelements (30) vorgesehen sind, die derart ausgeführt sind, daß unabhängig voneinander räumlich getrennte Teilbereiche des Speicherelements (30) schreib- oder lesbar sind.

12. Vorrichtung nach einem oder mehreren der Ansprüche 1 bis 11, dadurch gekennzeichnet, daß Teile der Vorrichtung mehrfach vorgesehen sind und/oder mehrere Strahlen handhaben.

13. Vorrichtung nach einem oder mehreren der Ansprüche 1 bis 12, dadurch gekennzeichnet, daß alle oder ein Teil der Strahlen ganz oder teilweise durch Lichtleiter geführt werden und/oder, daß alle oder ein Teil der optischen Elemente durch Mittel der integrierten Optik realisiert werden.

14. Verwendung einer Vorrichtung nach einem oder mehreren der Ansprüche 1 bis 13 als Vorrichtung zur optischen Aufnahme, Speicherung und/oder Wiedergabe von Informationen.

15. Verfahren zur optischen Aufnahme von Informationen, bei dem in einem Speicherelement (30), das eine lichtbeugende Struktur aufweist und/oder in dem lichtbeugende Strukturen erzeugbar sind, zum Zwecke der Aufnahme wenigstens zwei Lichtstrahlen unter Bildung eines Interferenzmusters zusammengeführt werden,
**dadurch gekennzeichnet,**
daß zwischen jeweils zwei Aufnahmen die räumliche Orientierung des durch die Lichtstrahlen erzeugten Interferenzmusters gegenüber der räumlichen Orientierung eines gespeicherten Interferenzmusters und/oder einer lichtbeugenden Struktur in allen Raumrichtungen verändert werden kann.

16. Verfahren zur optischen Wiedergabe von Informationen aus einem Speicherelement (30), das lichtbeugende Strukturen aufweist, bei dem
zum Zwecke des Nachweises einer lichtbeugenden Struktur wenigstens zwei Lichtstrahlen unter Bildung eines Interferenzmusters zusammengeführt werden,
wobei die Frequenz oder die Phasenlage mindestens eines der Lichtstrahlen gegenüber dem anderen variiert und/oder moduliert wird und wobei wenigstens einer der Lichtstrahlen von dem Speicherelement (30) ausgeht und von einem Detektor (70,70') erfaßt wird
und wobei eine zeitliche oder räumliche Modulation dieses Lichtstrahls mittels eines Demodulators (80) demoduliert wird,
**dadurch gekennzeichnet,**
daß zum Nachweis verschiedener lichtbeugender Strukturen die Ausbreitungsrichtung mindestens eines der zur Interferenz beitragenden Lichtstrahlen gegenüber der räumlichen Orientierung einer im Speicherelement (30) gespeicherten lichtbeugenden Struktur in allen Raumrichtung verändert werden kann.
